# EUROPEAN PATENT APPLICATION

(11) **EP 2 270 102 A1**
(43) Date of publication of application: **05.01.2011**
(21) Application number: 09722725.0
(22) Date of filing: 19.03.2009
(51) Int. Cl.: C08L 101/00, C08K 3/00, C08K 5/109, C08K 5/41, C08K 5/45, C08L 63/00, C08L 75/04, H05K 3/28

(54) **RESIN COMPOSITION AND CURED FILM THEREOF**

(30) Priority: 21.03.2008 JP 2008072803
(71) Applicant: Showa Denko K.K., Tokyo 105-8518 (JP)
(72) Inventor: ONISHI, Mina, Tokyo 105-8518 (JP)
(74) Representative: Strehl Schübel-Hopf & Partner
(86) International application number: PCT/JP2009/055389
(87) International publication number: WO 2009/116609

(57) **Abstract**

The present invention relates to a resin composition comprising resin (A), a filler (B) and a solvent (C), wherein the solvent (C) contains at least one organic solvent selected from a group consisting of propylene carbonate, dimethylsulfoxide and sulfolane; a cured film obtained by curing the resin composition; and use of the cured film as an overcoat for electronic circuit boards or the like. The resin composition of the present invention has a high filtration rate when it is prepared and has excellent productivity. A cured film obtained by curing the resin composition has excellent long-term electric reliability and is useful in the fields of solder resists, electrical insulating materials such as interlayer dielectric films, encapsulating materials for ICs and ultra LSIs, laminates and the like.

## Description

### TECHNICAL FIELD

The present invention relates to a resin composition comprising resin, a filler and a solvent. More specifically, the present invention relates to a resin composition being exellent in the dispersibility of the filler and improved in the filtration when prepared as a resin composition used for an overcoat for electronic circuit boards and the like, which can provide an overcoat for electronic circuit boards and the like having excellent long-term electrical reliability; a cured film obtained by curing the resin composition; and use of the cured film.

### BACKGROUND ART

Conventionally, as a surface protection film of flexible wiring circuit, types of insulating protection film called cover-lay film (such as polyimide film) stamped out with a mold to be stuck with an adhesive and UV-cured or heat-cured overcoating agents having flexibility have been used.

However, with recent reduction in size and weight of electronic devices, as flexible substrates tend to be lighter and thinner, the pitch in printed wiring becomes significantly narrower, and dispersibility of the filler in the resin composition for overcoating is exerting more and more influence on the long-term electrical reliability. Therefore, the filtration step becomes essential in the production of the resin composition for overcoating to make the average diameter size of the filler in the resin composition within a specific range, and in accordance with the printed-wiring pitch, the filter diameter tends to be smaller. To maintain the long-term electric reliability with a narrow printed wiring pitch, it is desirable to filter the resin composition used for an overcoat with a filter diameter which is narrower than half the distance between the printed wiring. However, in this case, the filtration rate becomes significantly slower and not only the productivity but the yield decreases, which imposes an economic burden. Accordingly, it has been demanded to improve the dispersibility of the filler without changing machining processes to thereby increase the filtration rate to improve the productivity.

As a prior art disclosing the use of an aprotic polar solvent for insulating resin and printed wiring boards using the same, JP-A-2007-77234 (Patent Document 1) discloses an insulating resin composition comprising silica (component A), epoxy resin (component B), a silane coupling agent containing epoxy group or amino group as a functional group (component C), and a solution (component E) containing at least one solvent (component D) selected from dimethylformamide (DMF), N-methyl-2-pyrrolidone (NMP) and dimethylacetamide (DMAC), wherein s solvent (component D) is used for the purpose of preventing silica particles from aggregating between each other.

JP-A-H04-249523 (Patent Document 2; U.S. Patent No. 5,395,911) discloses a thermoset mixture using propylene carbonate. The publication describes a mixture containing aromatic diglycidyl ethers or aromatic polyglycidyl ethers and a formamide compound in claim 1, a mixture further containing cyclocarbonate as a preferable embodiment (claim 2) and propylene carbonate as a specific example of cyclocarbonate (claim 14). However, cyclocarbonate is primarily used as a reactive diluent in Patent Document 2, which neither teaches nor suggests at all that cyclocarbonate improves the dispersibility of the filler.

- Patent Document 1:: JP-A-2007-77234
- Patent Document 2:: JP-A-H04-249523

### DISCLOSURE OF THE INVENTION

### [Problems to be Sovled by the Invention]

Thus, an objective of the present invention is to provide a resin composition which is capable of improving the dispersibility of the filler to improve the filtration rate when the resin composition is prepared, and capable of forming a cured product excellent in productivity and long-term electric relaiability; particularly a resin composition used for an overcoat for electronic circuit boards and a resin composition for solder resist ink.
Another objective of the present invention is to provide a cured film obtained by curing the above-mentioned resin composition; and the use of the cured film for flexible printed-wiring boards, chip on film printed-wiring boards and electronic devices using the printed-wiring boards.

### [Means to Solve the Problems]

As a result of intensive studies to solve the above problems, the present inventors have found that the dispersibility of silica and other filler can be improved by using as an essential component a specific aprotic polar solvent (i.e. propylene carbonate, dimethylsulfoxide and sulfolane) other than dimethylformamide (DMF), N-methyl-2-pyrrolidone (NMP) and dimethylacetamide (DMAC) disclosed by Patent Document 1; and as a result that the filtration rate of the resin composition when prepared can be improved and the resin composition can be extremely useful as a resin composition for industrial use in handling overcoats for electronic circuit boards and the like at a large scale, which composition is capable of forming a cured film excellent in the long-term electric reliability. The present inventors have accomplished the present invention based on this finding.

That is, the present invention relates to the following.
[1] A resin composition comprising resin (A), a filler (B) and a solvent (C), wherein the solvent (C) contains at least one organic solvent selected from a group consisting of propylene carbonate, dimethylsulfoxide and sulfolane.
[2] The resin composition as described in [1] above, wherein resin (A) is a thermosetting or UV-cured resin.
[3] The resin composition as described in [2] above, wherein the thermosetting resin is polyurethane resin containing carboxyl group and/or an epoxy compound.
[4] The resin composition as described in any one of [1] to [3] above, wherein solid content concentration in the resin composition is 40 to 80 mass %.
[5] The resin composition as described in [1] above, wherein solvent (C) is a mixed solvent of at least one organic solvent selected from a group consisting of propylene carbonate, dimethylsulfoxide and sulfolane and the other solvent which dissolves resin (A).
[6] The resin composition as described in any one of [1] to [5] above, wherein the viscocity of the resin composition at 25°C is 15,000 to 200,000 mPa·s; and when the resin composition was subjected to pressure filtration at 40°C and 0.4 MPa using a cartridge filter having an effective filter area of 500 cm² which is capable of filtering with the 98% or higher retention of particles having a diameter of 10 to 20 µm, the initial filtration rate is 20 g/min. or higher and the ratio of the filtration rate of 30 minutes after the start of the filtration to the initial filtration rate is 70% or higher.
[7] The resin composition as described in any one of [1] to [5] above, wherein the viscocity of the resin composition at 25°C is 15,000 to 200,000 mPa·s; and when the resin composition was subjected to pressure filtration at 40°C and 0.4 MPa using a cartridge filter having an effective filter area of 600 cm² which is capable of filtering with the 98% or higher retention of particles having a diameter of 5 to 10 µm, the initial filtration rate is 20 g/min. or higher and the ratio of the filtration rate of 30 minutes after the start of the filtration to the initial filtration rate is 70% or higher.
[8] The resin composition as described in [1] above, wherein filler (B) contains a filler having an average diameter on a mass basis of 0.01 to 3 µm.
[9] The resin composition as described in [1] or [8] above, wherein filler (B) contains barium sulfate and/or silica.
[10] A cured film obtained by curing the resin composition described in any one of [1] to [9] above.
[11] An overcoat for electronic circuit boards comprising a cured film of the resin composition described in any one of [1] to [9] above.
[12] A flexible printed wiring board, the surface of which is partially or entirely coated with a cured film of the resin composition described in any one of [1] to [9].
[13] A chip-on film printed wiring boards coated by the cured film of the resin composition described in any one of [1] to [9] above.
[14] Electronic devices in which the flexible printed wiring board described in [12] above or the chip on film for printed wiring boards described in [13] above is embedded.
[15] The resin composition as described in any one of [1] to [9] above, which is a composition for an overcoat of electronic circuit boards.
[16] The resin composition as described in any one of [1] to [9] above, which is a composition for solder resist ink.

### EFFECTS OF THE INVENTION

The resin composition of the present invention comprising as essential components resin (A), filler (B) and solvent (C) which contains at least one organic solvent selected from a group consisting of propylene carbonate, dimethylsulfoxide and sulfolane can improve the dispersibility of filler (B) and filtration rate when the resin composition is prepared and the composition is easy to handle in industrial use at a large scale. Accordingly, the present invention makes it easy to produce a substantially uniform resin composition, wherein the filler would not step over the pitch of the printed wiring of electronic circuit boards. The thus-obtained resin composition can be suitably used for solder resist ink and ink for an overcoat used as an electrical insulating material such as an interlayer dielectric film; and the cured product of the resin composition being excellent in the long-term electric reliability can be suitably used for a flexible printed wiring board, laminates and the like in which the cured product of the ink is used.

### BEST MODE FOR CARRYING OUT THE INVENTION

The resin composition of the present invention is explained in details hereinbelow.
The resin composition of the present invention is particularly used for a surface protection film for electronic circuit boards. A resin composition used for such purposes is required to excel in properties such as electrical insulation, long-term electrical reliability, durability and to exhibit low thermal expansion coefficient. To meet the requirements, it is essential for the resin composition to incorporate filler (B) in resin (A) and to contain solvent (C) which provides flowability with the composition to thereby enable forming a coating film onto the electronic circuit boards.

The present inventors have found that the affinity of filler (B) and resin (A) becomes higher to thereby improve dispersibility of the filler in the resin composition by using as solvent (C) a solvent which contains at least one specific aprotic polar solvent, even when a resin composition has a high solid content concentration and high viscosity. As a result of further studies, the present inventors confirmed that, among aprotic polar solvents, an aprotic solvent containing an organic carbonate compound (propylene carbonate) and a dipole moment: i.e. dimethylsulfoxide and sulfolane are highly effective in improving dispersibility of the filler.
Here, a solid content means a heating residue after the resin composition is heated at 120°C for one hour and subsequently at 150°C for two hours, which mainly comprises polymer and a filler when the resin composition contains a filler, and includes unreacted momoners at the time of producing a polymer in a strict sense.

The present inventors made a study on solvents other than DMF, NMP and DMA which are disclosed in Patent Document 1 to find out a solvent capable of improving the dispersibility of the filler.
The inventors made a study on ethylene carbonate, propylene carbonate, dimethyl carbonate, diethyl carbonate, divinyl carbonate, di-n-propyl carbonate, diisopropyl carbonate, di-sec-butyl carbonate, dihexadecyl carbonate, di-2-ethylhexyl carbonate, dicyclohexyl carbonate and the like as an organic carbonate compound and have found that propylene carbonate is particularly preferable among these. Propylene carbonate not only provides an excellent dispersibility of filler (B) but is also easy to handle; and therefore can be extremely useful for industrial use at a large scale.

The present inventors made further studies on chloroform, diethyl ether, tetrahydro furane (THF), dioxane, acetone, acetonitrile, nitrobenzene, nitromethane, pyridine, dimethylformamide (DMF), dimethylacetamide, dimethylsulfoxide and sulfolane as an aprotic solvent containing a dipole moment. As a result, they have found that dimethylsulfoxide and sulfolane are preferable among these. Dimethlsulfoxide and sulfolane not only provide an excellent dispersibiliy of filler (B) but is also easy to handle; and therefore can be extremely useful for industrial use at a large scale.

That is, the resin composition of the present invention is a resin composition containing resin (A), filler (B) and solvent (C), wherein solvent (C) contains at least one kind of organic solvents selected from the group consisting of propylene carbonate, dimethylsulfoxide and sulfolane.

There are no particular limitations on solvent (C) as long as it contains propylene carbonate as an organic carbonate compound and at least one kind of organic solvents selected from the group consisting of dimethylsulfoxide and sulfolane as an aprotic solvent having a dipole moment; and solvent (C) may contain the other solvent which dissolves resin (A).

Among propylene carbonate, dimethylsulfoxide and sulfolane which are incorporated into the resin composition of the present invention for the purpose of improving the dispersibility of the filler, dimethylsulfoxide generate peculiar sulfurous odor when a curable resin composition using dimethylsulfoxide as a solvent is cured by heating; and therefore may be limited in its usefuleness. Since sulfolane is solid at normal temperature, it needs to be mixed with other solvents in advance to make it available at normal temperature. Therefore, propylene carbonate can be said to be most advantageous among these solvents.

The solid content concentration in the resin composition is preferably 40 to 80 mass %. When the solid content concentration is less than 40 mass %, it lowers the viscosity of the resin composition, resulting in improvement in wettability with the filler as well as dispersibility, which enables to accelerate the filtration rate. However, due to the decrease in the solid content concentration of the resin composition, not only that a sufficient thickness as a surface protection film cannot be obtained, but print precision cannot be maintained either since the resin composition flows into the space between the wirings of the electronic circuit boards other than the surface having a wiring pattern formed by capillary action when the resin composition is printed onto electronic circuit boards. Also, when the solid content concentration decreases and the solvent component increases, it makes the solvent less likely to be volatilized at the formation of a surface protection film and easier to remain, and the remaining solvent may be volatilized in the subsequent steps, which may worsen working conditions. Though it may be possible to prevent the capillary action at the time of printing by increasing the additive amount of the filler to resin, it makes the surface protection film fragile and causes cracks or decreases the film strength and therefore is not desirable.

On the other hand, when the solid content concentration of the resin composition exceeds 80 mass %, the wettability of the filler becomes inferior, which makes the dispersion difficult and is not desirable. Though the filtration rate may be improved by decreasing the additive amount of the filler to resin, it is not desirable because one cannot expect inherent advantages such as endurability and and low thermal expansion coefficient as a protection film to which the filler makes contribution.

In the present invention, examples of the other solvents which is capable of dissolving resin (A) to be used in mixture with propylene carbonate, dimethylsulfoxide and sulfolane include a solvent having a glycol skeleton, which is excellent in compatibility with resin, has less odor and is easy to handle. Specific examples include ethyleneglycol dimethylether, ethyleneglycol diethylether, carbitol acetate, propyleneglycol methyletheracetate, dipropyleneglycol methyletheracetate, ethylcarbitol acetate and butylcarbitol acetate. Examples of the other solvents include γ-butyrolactone, toluene, xylene, ethylbenzene, nitrobenzene, isophorone, methyl methoxypropionate, ethyl ethoxypropionate, n-butyl acetate, N,N-dimethylformamide and N-methylpyrrolidone.

Propylene carbonate, dimethylsulfoxide and sulfolane used for the resin composition of the present invention do not always have to be a good solvent of resin (A) as long as the solvent is capable of dissolving resin (A) when the solvent is used as a mixed solvent in combination with the above-mentioned solvent having a glycol skeleton and the other solvents.

The additive amount of propylene carbonate, dimethylsulfoxide and sulfolane is an amount as much as necessary to work as a dispersion aid of filler (B). Generally, adequate effect of improving the dispersion of the filler can be obtained by using propylene carbonate, dimethylsulfoxide and sulfolane within the range of 1 to 50 mass % to the total of solvent (C) in the resin composition and the range of 5 to 100 parts by mass, preferably 15 to 100 parts by mass to 100 parts by mass of the filler.

Examples of resin (A) contained in the resin composition of the present invention include natural resin, modified resin and oligomer synthetic resin.

Specific examples of natural resin include rosin resin, dammar, mastic and balsamic resin. Examples of modified resin include rosin derivatives and rubber derivatives. Examples of oligomer synthetic resin include epoxy resin, acrylic resin, maleic acid derivatives, polyester resin, melamine resin, polyurethane resin, polyimide resin, polyamic acid resin and polyimide-polyamide resin.

Curable resin which can be cured by heat or ultraviolet is preferable to maintain the film strength as a surface protection film.

Examples of heat-curable resin include carboxyl group-containing polyurethane resin; epoxy resin; or a resin obtained by reacting a compound containing acid anhydride group, carboxyl group, alcoholic group and amino group with an epoxy compound; and a resin obtained by reacting a compound containing carboxyl group, alcoholic group and amino group with carbodiimide. Furthermore, examples of heat-curable resin include polyimide silica hybrid, HBAA-02 (manufactured by Arakawa Chemical Industries, Ltd.) in which an alkoxysilane compound is reacted with a specific site of polyamic acid resin to thereby enable thermal curing by a ring-closing reaction of imide and hydrolysis and condensation of alkoxysilane.

Examples of epoxy resin include a resin obtained from an epoxy compound containing two or more epoxy groups in one molecule such as bisphenol A-type epoxy resin, hydrogenated bisphenol A type epoxy resin, brominated bisphenol A-type epoxy resin, bisphenol F-type epoxy resin, novolak type epoxy resin, phenol-novolak type epoxy resin, cresol-novolak type epoxy resin, alicyclic epoxy resin, N-glycidyl type epoxy resin, novolak type epoxy resin of bisphenol A, chelate type epoxy resin, glyoxal type epoxy resin, amino group-containing epoxy resin, rubber-modified epoxy resin, dicyclopentadiene phenolic-type epoxy resin, silicone-modified epoxy resin and ε-caprolactone modified epoxy resin.

In addition, flame-retardant epoxy resin having halogen atoms such as chlorine and bromine or other atoms such as phosphor introduced in the srtucture may be used. Further, resins such as bisphenol S-type epoxy resin, diglycidylphthalate resin, heterocyclic epoxy resin, bixylenol type epoxy resin, biphenol type epoxy resin and tetraglycidyl xylenoyl ethane resin may be used.

Preferred epoxy resin is the one obtained by using an epoxy compound having two or more epoxy groups in one molecule. However, an epoxy compound having only one epoxy group may also be used in combination. There are no particular limitations on a carboxy group-containing compound, an alcoholic group-containing compound and an amino group-containing compound, which are to be used in combination with an epoxy compound or carbodiimide, and examples of the compounds include a polymer obtained by using a monomer containing a carboxyl group such as acrylic acid and methacrylic acid, a monomer containing an alcoholic group such as hydroxy acrylate and hydroxy methacrylate or a monomer containing an amino group such as allylamine and aminoalkyl acrylate as a monomer component at the time of polymerizing an acrylic resin.

Examples of ultraviolet curable resin include an acrylic copolymer which is a compound containing two or more ethylenic unsaturated groups, epoxy (meth)acrylate resin and urethane (meth)acrylate resin.

These resin (A)s may be used singly or in combination of two or more thereof. Carboxyl group-containing polyurethane resin and/or an epoxy compound are particularly preferred for use in the present invention.

When the resin composition of the present invention is used for screen-printing of electronic circuit boards, a viscosity within a specific range is required for the resin composition. That is, the viscosity measured with a rotor rotating with 1 rpm (rotations per minute) using an E-type viscometer at 25°C is generally within the range from 15,000 to 200,000 mPa·s, preferably within the range from 20,000 to 190,000 mPa·s. When the viscosity is less than 15,000 mPa·s, the resin composition will be of no practical use due to serious dripping at the time of screen printing. On the other hand, when the viscosity exceeds 200,000 mPa·s, it becomes necessary to enlarge the mesh size of the screen printing, which results in greater surface roughness and is not desirable.

It is not appropriate to evaluate the dispersibility of filler (B) in a resin composition having a solid content concentration within a range of 40 to 80 mass % and a viscosity within a range of 15,000 to 200,000 mPa·s using a particle diameter distribution analyzer, which requires a high dilution rate due to the measurement principle. Particularly, not a particle size of filler (B) but the aggregation between each other of particles and flocculation greatly influences on the filtration rate when the resin composition of the present invention is prepared. Therefore, it is desirable to evaluate the dispersibility without changing the concentration of the composition. As a result of intensive studies, it was found out that it is necessary to evaluate the dispersibility of filler (B) by actually filtering the resin composition and measuring the filtration rate and filter life.

A common filtration device can be used as a measurement device, but a device capable of pressure filtration which can handle a resin composition having a high viscosity is desirable; and as a filter, a cartridge which withstands the pressure filtration is more suitable than a membrane.

As a specific example of evaluation methods, it has been found that the dispersibility of filler (B) can be substantially evaluated by measuring the initial filtration rate and change in the flow rate (filtration life) when the resin composition is subjected to pressure filtration at 40°C and 0.4 MPa using a cartridge filter having an effective filter area of 500 cm² (MCP-7-C10E; manufactured by ADVANTEC Toyo Kaisha, Ltd.) which is capable of filtering with the 98% or higher retention of particles having a diameter of 10 to 20 µm. Particulary, when the initial filtration rate, which is defined as an average filtration rate (g/min.) for the first five minutes after the start of the filtration, is 20 g/min. or higher and when the ratio of the filtration rate of 30 minutes after the start of the filtration to the initial filtration rate is determined, it has been found that the resin composition having the filtration ratio of 70% or higher ensures uniformity required for industrial use at a large scale as well as productivity, while a resin composition having the ratio lower than 70% cannot ensure sufficient uniformity and is inferior in productivity.

Furthermore, when the cartridge filter to be used for the evaluation of the filtration rate is replaced with a cartridge filter having an effective filter area of 600 cm² (MCP-3-C10E; manufactured by Advantec Toyo Kaisha, Ltd.) which is capable of filtering with the 98% or higher retention of particles having a diameter of 5 to 10 µm and the resin composition is subjected to pressure filtration at 40°C and 0.4 MPa, the ratio of the filtration rate of 30 minutes after the start of the filtration to the initial filtration rate is determined, it has been found that the resin composition having the filtration ratio of 70% or higher can be applied to electronic circuit boards having a narrower pitch.

Examples of filler (B) used in the present invention include a filler obtained by mixing silicone oil with an inorganic support and powdering the mixture; a filler obtained by powdering urethane resin or acrylic resin; a fibrous reinforcing agent such as barium sulfate, silica, talc, calcium carbonate, alumina, glass powder and nitrided boron fiber; and synthetic mica. These fillers may be used alone or in combination of two or more thereof.

Filler (B) used in the present invention preferably has a mass mean diameter of 0.01 to 3 µm. When the mass mean diameter of the filler falls within the above-mentioned range, a flow rate can be ensured in the filtration step, which enables not only the extension of the filtration life but also application of the composition to electric circuit boards having an even narrower pitch. When the mass mean diameter of the filler is less than 0.01 µm, the filler is ready to reaggregate due to the large surface energy, and the filler will not contribute to imparting endurability to the composition, which is a primary role expected of the filler. On the other hand, when the mass mean diameter exceeds 3 µm, the composition becomes inferior in the filtration life and furthermore unsuitable for use in electronic circuit boards having a narrow pitch.
The composition amount of filler (B) having a mass mean diameter of 0.01 to 3 µm in the resin composition of the present invention is generally 5 to 1,000 parts by mass, preferably 10 to 100 parts by mass with respect to 100 parts by mass of the solid content of resin (A). Here, the solid content of resin (A) means a heating residue after the resin solution containing resin (A) before blending a filler into the solution is heated at 120°C for one hour and subsequently at 150°C for two hours.

The mass mean diameter in the present specification indicates a 50% accumulated diameter measured by a laser diffraction light-scattering particle size distribution analyzer Microtrack SPA (manufactured by Nikkiso Co., Ltd.) after 1 mass % of a filler to be measured is added to methanol and dispersed for four minutes using an ultrasonic homogenizer having a 150W output.

The composition of the present invention exerts a most remarkable effect when barium sulfate and/or silica are used as filler (B).

At the time of mixing resin (A), filler (B) and solvent (C) to prepare the resin composition of the present invention, the mixture may be heated so as to improve the compatibility. Also, at the time of mixing resin (A), filler (B), solvent (C) and other curing catalyst to be incorporated as needed and various additives, after dispersing or kneading the mixture by use of disperser, kneader, three-roll mill, beads mill and the like, a resin solution may be further added to the mixture, thereby stirring the mixture again to be made into a resin composition.

Additionally, according to the use, various known additives including colorants such as an organic pigment, antioxidants such as hindered amine-based compound, UV absorbents such as benzophenone-based compound, viscosity adjusting agent, antibacterial agent, fungicide, antistatic agent, plasticizer, lubricant, foaming agent, defoaming agent, leveling agent and compatibilizing agent may be blended into the composition.

By applying the resin composition of the present invention onto a asubstrate by screen-printing, followed by drying at 80°C for about 30 minutes and curing by heating at 100 to 150°C for one to two hours, a cured film suitable for use as an overcoat for electronic circuit boards can be obtained.
A resin composition for an overcoat of electronic circuit boards of the present invention is used to form an insulating protection film provided on the surface of a printed wiring board and the like for the purpose of ensuring insulation property between the wirings. An overcoat for electronic circuit boards is not only formed as a coating film on an object but also capable of sticking a separately formed film to an object by being applied onto an object for the purpose of providing electrical insulation and then volatilizing a solvent and/or conducting light and heat curing.

A printed circuit board indicates a structure in which the surface of a substrate having a metal wiring made of copper and the like on the base material is coated with an insulating protection film. As a base material, an epoxy resin-glass cloth (or nonwoven) composite material, an epoxy resin-paper composite material, a phenol resin-paper composite material, a bismaleimide-triazine (BT) resin-glass cloth (or nonwoven) composite material, a polyethylene terephthalate (PET) resin material, a polyimide resin material, a liquid crystal polymer material, a glass substrate and the like can be used. Metal wirings are provided on the both sides or one side of the base maerial. When the wiring is provided on both sides of the material, the wirings on the both sides are partially connected via a through-hole structure and the like in some structures. The wiring may be provided directly on the base material or be bonded to the material with an adhesive and the like. Furthermore, a printed circuit board also includes a structure so-called a flying lead structure, wherein a base material is partially removed and only the wiring remains. The wiring includes those in which a part or entire surface is subjected to plate processing such as gold plating and tin plating.

The resin composition of the present invention can be used for flexible printed circuit boards. Flexible printed circuit boards indicate foldable wiring boards among printed circuit boards. Specifically, examples of the flexible printed circuit boards include printed circuit boards using a resin film such as a polyethylene terephthalate (PET) resin substrate, a polyimide resin substrate and a liquid polymer substrate as a substrate.

The film obtained by curing the resin composition of the present invention can be used for chip-on-film (COF) wiring boards. A chip-on film (COF) is a kind of flexible printed circuit boards and has a structure in which a copper wiring is provided onto a resin film made of polyimide resin and the like, the surface of the film is coated with an insulating protection and a chip such as an IC and an LSI is mounted on the wiring board.

Accordingly, a chip-on film (COF) has a structure having a wiring portion coated with an insulating protection film for mounting a chip such as an IC and an LSI and a wiring portion without an insulating protection film for inputting and outputting signals. The structure of a chip-on film (COF) in which the cured product of the present invention exerts a particularly great effect is the one using polyimide resin as a substrate, wherein a copper wiring is provided on one side of the base material without an adhesive or the like and a part or entire surface of the copper wiring is plated with tin, and a wiring is provided on the polyimide resin substrate (i.e. not a flyng lead structure) in the portion for mounting a chip such as an IC and an LSI. For example, the cured product of the present invention is used for circuit boards for mounting a flat panel display driver IC (LSI) for displays such as a liquid crystal display television, a plasma television, a liquid crystal monitor and a liquid crystal display of a personal computer and the like.

In keeping with the increase in the number of pins of an IC, an LSI and the like with enhancement of the screen resolution, the wiring pitch tends to even narrower in these chip-on films (COF) as a driver chip and there has been a growing demand for even higher filtration rate of the resin composition making up a surface protection film. Chip-on films (COF) having a 30 µm to 40 µm pitch (the sum of a wiring width and a pitch) are mass-produced these days and a design having a 25 µm or 20 µm pitch is planned to be added to the production in the future, and attaining a fine wiring and a long-term electrical reliability of an insulating protection film between the wirings and on the wiring have become inevitable challenges. The resin composition of the present invention is a resin composition capable of meeting the challenges.

### EXAMPLES

The present invention is further described below by referring to Synthesis Examples, Examples and Comparative Examples but the present invention is by no means limited to the Examples.

### [Method for evaluating the filtration rate]

When the obtained resin composition is subjected to pressure filtration at 40°C and 0.4 MPa using a PP pleated compact cartridge filter "MCP-3-C10S" (nominal pore diameter: 3 µm; retention of particles having a diameter of 5 to 10 µm: 98%; manufactured by ADVANTEC Toyo Kaisha, Ltd.), the change of the filtration rate of 30 minutes after the start of the filtration to the initial filtration rate to the initial filtration rate (an average in the first five minutes after the start of the filtration; g/min.) was measured and evaluated according to the following criteria.
⊚: The initial filtration rate exceeds 25 g/min. and the ratio of the filtration rate of 30 minutes after the start of the filtration to the initial filtration rate is 70% or higher.
○: The initial filtration rate is from 20 to 25 g/min. and the ratio of the filtration rate of 30 minutes after the start of the filtration to the initial filtration rate is 70% or higher.
△: The ratio of the filtration rate of 30 minutes after the start of the filtration to the initial filtration rate is 50% or more and less than 70%.
×: The ratio of the filtration rate of 30 minutes after the start of the filtration to the initial filtration rate is less than 50%.

### [Printing conditions]

The resin composition was applied onto a commercial substrate (according to IPC standards) IPC-C (comb-shaped pattern; L/S = 30 µm/30 µm) by screen-printing using a #250-mesh polyester screen.

### [Curing conditions]

After printing under the above-mentioned printing conditions, the substrate was dried at room temperature for more than five minutes, and thermally cured at 150 °C for two hours under air atmosphere.

### [Method for evaluating long-term electric reliability]

To the thermally cured substrate, bias voltage of 100 V was applied in an atmosphere of relative humidity of 85 % at 85 °C and after the substrate was left standing for 2000 hours, the insulating property was evaluated based on the following standards.
○: Neither migration nor decrease in insulation resistance was observed
△: Some migration or some decrease in insulation resistance was observed within 1000 to 2000 hours.
×: Some migration or some decrease in insulation resistance was observed within 1000 hours.

### [Evaluation of the thermal resistance]

The thermally cured substrate was placed on a hot plate of 420°C for ten seconds and the change in color was observed to evaluate the thermal resistance based on the following standards.
○: No change in color was observed.
△: Slight change in color was observed.
×: Change into yellow or brown was observed.

### [Evaluation of printability]

The distance of the printing bleeding from the print edge into a space between wirings with a digital microscope VH-8000 (manufactured by Keyence Corporation) to evaluate the printability based on the following standards.
○: The distance of the printing bleeding from the print edge is less than 100 µm.
△: The distance of the printing bleeding from the print edge is 100 µm or more and less than 150 µm.
×: The distance of the printing bleeding from the print edge is 150 µm or more.

### Synthesis Example:

707 g of "C-1065N" (the molar ratio of the raw material diols; 1,9-nonanediol : 2-methyl-1,8-octanediol = 65:35; molecular weight: 991; manufactured by Kuraray Co., Ltd.) as polycarbonate diol, 114 g of 2,2-dimethylol butanoic acid (manufactured by Nippon Kasei Chemical Co., Ltd.) as a dihydroxyl compound containing a carboxyl group; and 1079 g of diethylene glycol ethyl ether acetate (manufactured by Daicel Chemical Industries, Ltd.) as a solvent were placed into a reactor provided with a stirrer, a thermometer and a capacitor and all the materials were dissolved at 90°C. The temperature of the reaction solution was lowered to 70°C and 258 g of "T-80" (a mixture of 2,4-trilene diisocyanate and 2,6-trilene diisocyanate at a ratio of 80:20; manufactured by Mitsui Takeda Chemicals, Inc.) as polyisocyanate was added by dropwise using a dripping funnel over 30 minutes. After dripping is completed, the reaction was performed at 80°C for one hour, at 90°C for one hour and at 100°C for two hours till isocyanate was consumed. The consumption was judged by measuring the infrared absorption spectrum of the reaction solution and confirming the disappearance of a peak in the vicinity of 2300 cm⁻¹ which is attributed to isocyanate. Then 7 g of isobutanol (manufactured by Wako Pure Chemical Industries, Ltd.) was added by dropwise and the reaction was performed at 105 °C for another 1.5 hours to obtain 2,165 g of polyurethane containing a carboxyl group (U-1).
The obtained carboxyl group-containing polyurethane (U-1) was found to have a solid content concentration of 50 mass %, a number average molecular weight of 12,000 and an acid value of the solid content of 39.9 mgKOH/g.

### Example 1

After 500 g of diethylene glycol ethyl ether acetate as a solvent, 200 g of propylene carbonate (PC) and 200 g of a solution of polyurethane (U-1) obtained in Synthesis Example 1 were stirred briefly, 10 g of "1B2MZ" (manufactured by Shikoku Chemicals Corporation) as a heat-curing catalyst, 200 g of barium sulfate (mass mean diameter: 0.5 µm) and 200 g of AEROSIL #380 (the trade name of fine silica particles manufactured by Nippon Aerosil Co., Ltd.; mass mean diameter: 12 nm) as fillers and 5 g of FLOWLEN AC300HF (manufactured by Kyoeisha Chemical Co., Ltd.) as a defoaming agent were kneaded coarsely and then subjected to finishing kneading by repeating kneading three times using a three-roll mill.

Furthermore, 1800 g of solution of polyurethane (U-1) and 132 g (the amount to contain one equivalent of epoxy groups to the carboxyl groups in the polyurethane solution) of epoxy resin "EPIKOTE 828 EL" (manufactured by Japan Epoxy Resins Co., Ltd.) were added to the mixture and stirred with a resin mixer; and adjusted with diethylene glycol ethyl ether acetate so that the mixture has a viscosity of 185,000 mPa·s to obtain 3150 g of resin composition having a solid content concentration of 45 mass %.
The filtration rate, long-term electrical reliability, thermal resistance and printability of the composition were evaluated and the results are shown in Table 1.

### Example 2

After 1200 g of dimethylsulfoxide (DMSO) and 200 g of solution of polyurethane (U-1) obtained in Synthesis Example 1 as a solvent and 500 g of STAPHYLOID AC3664 (manufactured by GANZ Chemical Co., Ltd.; core-shell polymer in the rubber state; mass mean diameter of 0.1 µm) as a filler were briefly stirred, 10 g of "2MZ" (manufactured by Shikoku Chemicals Corporation) as a heat-curing catalyst and 200 g of barium sulfate, and 30.0 g of "silicone defoamer TSA 750" (manufactured by GE Toshiba Silicones Co., Ltd.) as a defoaming agent were kneaded coarsely and then subjected to finishing kneading by repeating kneading three times using a three-roll mill. Furthermore, 1800 g of solution of polyurethane (U-1) and 132 g of epoxy resin "EPIKOTE 828 EL" were added to the mixture stirred with a resin mixer; and diluted with γ-butyrolactone to obtain 4210 g of resin composition having a viscosity of 100,000 mPa·s and a solid content concentration of 44 mass %.
The filtration rate, long-term electrical reliability, thermal resistance and printability of the composition were evaluated and the results are shown in Table 1.

### Example 3

After 1000 g of diethylene glycol ethyl ether acetate and 200 g of sulfolane as a solvent and 1000 g of epoxy resin "EPIKOTE 1007" (manufactured by Japan Epoxy Resins Co., Ltd.) were fully stirred in a warming bath at 50°C, 30 g of "1B2MZ" as a hear-curing agent, 30 g of melamine (mass mean diameter of 3 µm), 200 g of 5000PJ (fine talc powder manufactured by Matsumura Sangyo Co.; mass mean diameter of 1.7 µm), 100 g of AEROSIL #380, and 20 g of FLOWLEN AC300HF as a defoaming agent were kneaded coarsely and then subjected to finishing kneading by repeating kneading three times using a three-roll mill. Furthermore, the mixture was adjusted with diethylene glycol ethyl ether acetate so that the mixture has a viscosity of 32,000 mPa·s to obtain 2885 g of resin composition having a solid content concentration of 42 mass %.
The filtration rate, long-term electrical reliability, thermal resistance and printability of the composition were evaluated and the results are shown in Table 1.

### Example 4

After 500 g of diethylene glycol ethyl ether acetate, 200 g of propylene carbonate (PC) and 200 g of solution of polyurethane (U-1) obtained in Synthesis Example 1 were briefly stirred, 10 g of "1B2MZ", 200 g of barium sulfate, 200 g of AEROSIL #380 and 5 g of "FLOWLEN AC300HF" were kneaded coarsely and then subjected to finishing kneading by repeating kneading three times using a three-roll mill.
Furthermore, 1800 g of solution of polyurethane (U-1), 132 g of epoxy resin "EPIKOTE 828 EL" and 1000 g of diethylene glycol ethyl ether acetate were added to the mixture and stirred with a resin mixer; and adjusted with diethylene glycol ethyl ether acetate so that the mixture has a viscosity of 18,000 mPa·s to obtain 4050 g of resin composition having a solid content concentration of 35 mass %.
The filtration rate, long-term electrical reliability, thermal resistance and printability of the composition were evaluated and the results are shown in Table 1.

### Comparative Example 1

3250 g of resin composition was obtained in the same manner as in Example 1 except that only diethylene glycol ethyl ether acetate was used as a solvent without using propylene carbonate (PC). The filtration rate, long-term electrical reliability, thermal resistance and printability of the composition were evaluated and the results are shown in Table 1.

### Comparative Example 2

2200 g of resin solution having a viscosity of 50,000 cP was obtaind by stirring 200 g of propylene carbonate (PC) and 2000 g of solution of polyurethane (U-1) obtained in Synthesis Example 1 by a resin mixer without using a filler. The filtration rate, long-term electrical reliability, thermal resistance and printability of the composition were evaluated and the results are shown in Table 1.

**Table 1**

| Examples & Comparative Examples | Component of the composition | Filtration rate | Long-term electric reliability | Thermal resistance | Printability |
|---|---|---|---|---|---|
| Example 1 | PC | ⊚ | ○ | ○ | ○ |
| Example 2 | DMSO | ○ | ○ | ○ | ○ |
| Example 3 | Sulfolane | ○ | ○ | ○ | ○ |
| Example 4 | PC (*1) | ○ | ○ | ○ | △ |
| Comparative Example 1 | (*2) | × | ○ | ○ | ○ |
| Comparative Example 2 | (*3) | ○ | ○ | × | × |

| | | | | | |
|---|---|---|---|---|---|
| (*1) Low viscosity, low solid content (*2) An aprotic polar solvent is not used (*3) A filler is not contained | | | | | |

### INDUSTRIAL APPLICABILITY

The present invention enables obtaining a resin composition which is exellent in the dispersibility of the filler and improved in the filtration when a resin composition is prepared; and can provide an overcoat for electronic ciurcuit boards and the like, which can provide an overcoat for electronic circuit boards having excellent long-term electrical reliability. The resin composition of the present invention is useful in the field of a heat-curable resin composition for an overcoat for flexible printed circuits having an excellent flexibility; electric insulating materials such as solder resist and interlayer insulating films being excellent in insulating property; encapsulating materials for ICs and ultra LSIs; laminates and the like.

## Claims

1. A resin composition comprising resin (A), a filler (B) and a solvent (C), wherein the solvent (C) contains at least one organic solvent selected from a group consisting of propylene carbonate, dimethylsulfoxide and sulfolane.

2. The resin composition as claimed in claim 1, wherein resin (A) is a thermosetting or UV-cured resin.

3. The resin composition as claimed in claim 2, wherein the thermosetting resin is polyurethane resin containing carboxyl group and/or an epoxy compound.

4. The resin composition as claimed in any one of claims 1 to 3, wherein solid content concentration in the resin composition is 40 to 80 mass %.

5. The resin composition as claimed in claim 1, wherein solvent (C) is a mixed solvent of at least one organic solvent selected from a group consisting of propylene carbonate, dimethylsulfoxide and sulfolane and the other solvent which dissolves resin (A).

6. The resin composition as claimed in any one of claims 1 to 5, wherein the viscocity of the resin composition at 25°C is 15,000 to 200,000 mPa·s; and when the resin composition was subjected to pressure filtration at 40°C and 0.4 MPa using a cartridge filter having an effective filter area of 500 cm² which is capable of filtering with the 98% or higher retention of particles having a diameter of 10 to 20 µm, the initial filtration rate is 20 g/min. or higher and the ratio of the filtration rate of 30 minutes after the start of the filtration to the initial filtration rate is 70% or higher.

7. The resin composition as claimed in any one of claims 1 to 5, wherein the viscocity of the resin composition at 25°C is 15,000 to 200,000 mPa·s; and when the resin composition was subjected to pressure filtration at 40°C and 0.4 MPa using a cartridge filter having an effective filter area of 600 cm² which is capable of filtering with the 98% or higher retention of particles having a diameter of 5 to 10 µm, the initial filtration rate is 20 g/min. or higher and the ratio of the filtration rate of 30 minutes after the start of the filtration to the initial filtration rate is 70% or higher.

8. The resin composition as claimed in claim 1, wherein filler (B) contains a filler having an average diameter on a mass basis of 0.01 to 3 µm.

9. The resin composition as claimed in claim 1 or 8, wherein filler (B) contains barium sulfate and/or silica.

10. A cured film obtained by curing the resin composition claimed in any one of claims 1 to 9.

11. An overcoat for electronic circuit boards comprising a cured film of the resin composition claimed in any one of claims 1 to 9.

12. A flexible printed wiring board, the surface of which is partially or entirely coated with a cured film of the resin composition claimed in any one of claims 1 to 9.

13. A chip-on film printed wiring boards coated by the cured film of the resin composition claimed in any one of claims 1 to 9.

14. Electronic devices in which the flexible printed wiring board claimed in claim 12 or the chip on film for printed wiring boards claimed in claim 13 is embedded.
